# EUROPEAN PATENT APPLICATION

(11) **EP 4 503 097 A1**
(43) Date of publication of application: **05.02.2025**
(21) Application number: 23779828.5
(22) Date of filing: 20.03.2023
(51) Int. Cl.: H01L 21/304, B24B 37/00, C08K 3/36, C08L 29/04, C08L 101/14, C09G 1/02, C09K 3/14, H01L 21/306

(54) **POLISHING COMPOSITION**

(30) Priority: 31.03.2022 JP 2022058671
(71) Applicant: Fujimi Incorporated, Kiyosu-shi, Aichi 452-8502 (JP)
(72) Inventor: MOMOTA, Satoshi, Kiyosu-shi, Aichi 452-8502 (JP); KOMOTO, Yukari, Kiyosu-shi, Aichi 452-8502 (JP); ICHITSUBO, Taiki, Kiyosu-shi, Aichi 452-8502 (JP); TSUCHIYA, Kohsuke, Kiyosu-shi, Aichi 452-8502 (JP)
(74) Representative: Grünecker Patent- und Rechtsanwälte PartG mbB
(86) International application number: PCT/JP2023/010850
(87) International publication number: WO 2023/189812

(57) **Abstract**

Provided is a polishing composition that can offer a high-grade surface. The polishing composition contains silica particles (A), a basic compound (B), a first water-soluble polymer (C1), a second water-soluble polymer (C2), and water (D), wherein the first water-soluble polymer (C1) is a polyvinyl alcohol-based polymer. A product (ER × ζ) of an etching rate ER [µm/h] of the polishing composition and zeta potential ζ [mV] of the polishing composition is -900 nmV/h or more and -90 nmV/h or less.

## Description

### [Technical Field]

The present invention relates to a polishing composition. The application claims the priority based on Japanese Patent Application No. 2022-58671, filed on March 31, 2022, the content of which is herein incorporated by reference in its entirety.

### [Background Art]

A surface of a material such as metal, semimetal, non-metal, or an oxide thereof has been finely polished with a polishing composition. For example, a surface of a silicon wafer used as a component of a semiconductor device or the like is generally finished into a high-grade mirror plane via a lapping step (rough polishing step) and a polishing step (fine polishing step). The polishing step typically includes a preliminary polishing step (stock polishing step) and a final polishing step (finish polishing step). Patent Documents 1-3 are exemplary technical references of a polishing composition mainly used in application of polishing a semiconductor substrate such as a silicon wafer.

### [Citation List]

### [Patent Literature]

[Patent Document 1] Japanese Patent No. 6185432
[Patent Document 2] Japanese Patent No. 6348927
[Patent Document 3] Japanese Patent No. 6232243

### [Summary of Invention]

### [Technical Problem]

A polishing composition for use has a polishing capability to efficiently polish an object to be polished. For example, polishing of a semiconductor substrate, such as a silicon wafer as described above, or other substrates can be leveraged by mechanical polishing action by abrasive and chemical polishing action by a basic compound (alkali etching), which provide higher removal ability. A polishing composition with high removal ability is preferred because it enables improvement in production efficiency, cost effectiveness, etc. In such polishing, use of silica particles as an abrasive enables efficient preparation of a polishing surface with good quality.

In addition, a polishing composition used in polishing of the substrate, such as a polishing composition used in a final polishing step (particularly, a final polishing step of a semiconductor substrate such as a silicon wafer, or other substrates), is also required to have performance to provide a high-quality surface after polishing. Improvement in a surface quality of a polishing surface is provided by, e.g., a method of protecting a substrate from alkali etching by a water-soluble polymer contained in a polishing composition. For example, Patent Documents 1-3 disclose polishing compositions that have silica particles, a basic compound, and a water-soluble polymer. However, in such polishing compositions containing an abrasive, a basic compound, and a water-soluble polymer, there has still been a room for reducing defects (e.g., LPD-N (light point defect non-cleanable)) and micro-scratches (e.g., haze-line) to provide an improved surface quality after polishing.

The present invention thus has an object to provide a polishing composition that can offer a high-grade surface.

### [Solution to Problem]

The description provides a polishing composition. The polishing composition contains silica particles (A) as an abrasive, a basic compound (B), a first water-soluble polymer (C1), a second water-soluble polymer (C2), and water (D), wherein the first water-soluble polymer (C1) is a polyvinyl alcohol-based polymer. A product (ER × ζ) of an etching rate ER [µm/h] of the polishing composition and zeta potential ζ [mV] of the polishing composition is -900 nmV/h or more and -90 nmV/h or less.

In the formula, the etching rate ER [µm/h] of the polishing composition is calculated based on the etching rate measurement as follows.

### [Etching Rate Measurement]

(1) Prepare the polishing composition as a liquid agent for etching rate measurement LE.
(2) Prepare a silicon single crystal substrate (having a rectangular shape with 6 cm in length, 3 cm in width, and 775 µm in thickness) by immersion in a cleaning liquid of NH₄OH (29%) : H₂O₂ (31%) : deionized water (DIW) = 2:5.3:48 (volume ratio) at 25°C for 1 minute and then in an aqueous hydrogen fluoride (HF) solution (5%) at 25°C for 30 seconds, and measure weight W0 of the silicon single crystal substrate.
(3) Immerse the silicon single crystal substrate in the liquid agent LE at 25°C for 48 hours.
(4) Remove the silicon single crystal substrate from the liquid agent LE, and clean the silicon single crystal substrate with a cleaning liquid of NH₄OH(29%) : H₂O₂(31%) : deionized water (DIW) = 1:1:8 (volume ratio) at 25°C for 10 seconds.
(5) After cleaning, measure weight W1 of the silicon single crystal substrate.
(6) Calculate the etching rate [µm/h] from a difference between the W0 and the W1 and the specific gravity of the silicon single crystal substrate.

Zeta potential ζ of the polishing composition can indicate dispersibility of particles in the polishing composition. In addition, an etching rate ER of the polishing composition can indicate performance to protect a surface to be polished from alkali etching of the polishing composition (hereinafter, also referred to as "performance for substrate protection"). The polishing composition disclosed herein exhibits a product (ζ × ER) of the zeta potential ζ and an etching rate ER within the aforementioned range, thus provides the polishing composition with well-balanced control of dispersibility and performance for substrate protection, and tends to offer a high-quality surface with reduced defects (e.g., LPD-N) and micro-scratches (e.g., haze-line) after polishing.

In some embodiments, the first water-soluble polymer (C1) is one or two or more kinds selected from the group consisting of unmodified polyvinyl alcohols with a saponification degree of 70% or more; acetalized polyvinyl alcohol-based polymers; and polyvinyl alcohol-based polymers containing repeating units derived from alkylvinyl ether. Use of such polymers as the first water-soluble polymer (C1) tends to provide a more improved surface quality after polishing.

In some embodiments, the content of the first water-soluble polymer (C1) relative to 100 parts by weight of the abrasive is 0.5 parts by weight or more and 10 parts by weight or less. Such composition can preferably offer an effect according to the art disclosed herein.

In some embodiments, the second water-soluble polymer (C2) is one or two or more kinds selected from the group consisting of polyvinyl alcohol-based polymers having a chemical structure different from that of the first water-soluble polymer (C1); nitrogen atom-containing polymers; and (meth)acrylic acid unit-containing polymers. Use of the second water-soluble polymer (C2) with the first water-soluble polymer (C1) tends to provide a more improved surface quality after polishing.

In some embodiments, the nitrogen atom-containing polymers are polymers containing, as a monomer unit, linear amide having an N-(meth)acryloyl group. Use of such polymers with the first water-soluble polymer (C1) tends to provide a more improved surface quality after polishing.

In some embodiments, the content of the second water-soluble polymer (C2) relative to 100 parts by weight of the abrasive is 0.5 parts by weight or more and 10 parts by weight or less. Such composition can preferably offer an effect according to the art disclosed herein.

In some embodiments, the polishing composition further contains a surfactant (E). Such composition tends to provide a more improved surface quality after polishing. In a preferred embodiment, the surfactant (E) is a nonionic surfactant.

The polishing composition disclosed herein can be preferably used in polishing of a surface made of a silicon material. Use of the polishing composition to polish a surface made of a silicon material enables efficient preparation of a high-quality surface made of a silicon material.

The polishing composition disclosed herein may be a concentrated liquid. The polishing composition disclosed herein may be produced, distributed, and stored in a concentrated liquid.

### [Description of Embodiments]

Preferred embodiments of the present invention will be described below. Matters that are other than those particularly mentioned herein but are necessary for implementation of the present invention can be recognized as matters to be designed by those skilled in the art based on conventional technologies in the art. The present invention can be implemented based on contents disclosed herein and common technical knowledge in the art.

### <Properties of Polishing Composition>

The polishing composition disclosed herein is characterized by zeta potential and an etching rate. As used herein, zeta potential of the polishing composition refers to zeta potential measured for the polishing composition by means of a zeta potential measurement device, and more particularly to zeta potential measured for particles in the polishing composition. Zeta potential of the polishing composition may indicate dispersibility of particles in the polishing composition. For example, when the polishing composition has negative zeta potential, a larger absolute value of zeta potential of the polishing composition represents increased electrostatic repulsion of particles, including abrasive, in the polishing composition, and is likely to indicate improved dispersibility of the polishing composition.

An etching rate of the polishing composition refers to an extent how a surface of an object to be polished is chemically corroded (etched) by a basic compound and the like in the polishing composition. In particular, an etching rate of the polishing composition is calculated based on the etching rate measurement described below. Note that a water-soluble polymer and the like in the polishing composition tend to have a function to be adsorbed to a surface of an object to be polished, and thereby protect the surface of the object to be polished from etching. Accordingly, an etching rate of the polishing composition may indicate performance of a water-soluble polymer and the like in the polishing composition to suppress an event where a surface of an object to be polished is etched by a basic compound and the like, i.e., performance of the polishing composition to protect a surface of an object to be polished (hereinafter also referred to as performance for substrate protection), under a condition with excluding an effect of mechanical action by abrasive. In the examples described later, an etching rate of the polishing composition is also defined by calculation based on the etching rate measurement as follows.

### [Etching Rate Measurement]

(1) Prepare a polishing composition as a liquid agent for etching rate measurement LE.
(2) Prepare a silicon single crystal substrate (having a rectangular shape with 6 cm in length, 3 cm in width, and 775 µm in thickness) by immersion in a cleaning liquid of NH₄OH (29%) : H₂O₂ (31%) : deionized water (DIW) = 2:5.3:48 (volume ratio) at 25°C for 1 minute and then in an aqueous hydrogen fluoride (HF) solution (5%) at 25°C for 30 seconds, and measure weight W0 of the silicon single crystal substrate.
(3) Immerse the silicon single crystal substrate in the liquid agent LE at 25°C for 48 hours.
(4) Remove the silicon single crystal substrate from the liquid agent LE, and clean the silicon single crystal substrate with a cleaning liquid of NH₄OH(29%) : H₂O₂(31%) : deionized water (DIW) = 1:1:8 (volume ratio) at 25°C for 10 seconds.
(5) After cleaning, measure weight W1 of the silicon single crystal substrate.
(6) Calculate an etching rate [µm/h] from a difference between the W0 and the W1 and the specific gravity of the silicon single crystal substrate.

The polishing composition disclosed herein exhibits a product of zeta potential and an etching rate within a predetermined range. A product of zeta potential and an etching rate falling within a predetermined range in the polishing composition represents a tendency that the polishing composition has dispersibility and performance for substrate protection each controlled to fall within a predetermined range. With such a configuration, the polishing composition tends to have an improved surface quality after polishing.

According to an embodiment in the art disclosed herein, a product (ER × ζ) of zeta potential ζ [mV] of the polishing composition and an etching rate ER [µm/h] of the polishing composition is -900 nmV/h or more and -90 nmV/h or less. When a product of zeta potential and an etching rate falls within the aforementioned range, the polishing composition has well-balanced control of dispersibility and performance for substrate protection, leading to a tendency to offer a high-quality surface with reduced defects (e.g., LPD-N) and micro-scratches (e.g., haze-line) after polishing.

In view of reduction in LPD-N, reduction in haze-line, and improvement in a surface quality after polishing, a product (ER × ζ) of zeta potential ζ [mV] of the polishing composition and an etching rate ER [µm/h] of the polishing composition is more preferably -870 nmV/h or more. In some embodiments, the ER × ζ may be -700 nmV/h or more, -500 nmV/h or more, -400 nmV/h or more, or -350 nmV/h or more. Similarly, in view of improvement in a surface quality, the ER × ζ may be -100 nmV/h or less, or -105 nmV/h or less, and is more preferably -115 nmV/h or less. In some embodiments, the ER × ζ may -200 nmV/h or less, -250 nmV/h or less, -300 nmV/h or less, or -400 nmV/h or less.

Zeta potential ζ of the polishing composition is not particularly limited, as long as a product with an etching rate ER falls within a specific range. The zeta potential ζ is usually less than 0 mV, and in view of dispersibility of the polishing composition, a surface quality of a polishing face, etc., it is suitably -5 mV or less, preferably -10 mV or less, more preferably -20 mV or less, even more preferably -25 mV or less, and particularly preferably -30 mV or less. In some embodiments, the zeta potential ζ may be -35 mV or less, -38 mV or less, or -45 mV or less. In view of improving a polishing removal rate, it is preferably -80 mV or more, more preferably -70 mV or more, even more preferably -60 mV or more, and possibly -45 mV or more. Zeta potential ζ of the polishing composition can be set corresponding to the kind or content of abrasive, the type, molecular weight, or content of a water-soluble polymer, the type or content of a basic compound, the presence or absence, type, content, or pH of another additive component added (a surfactant, etc.), or the like.

Zeta potential of the polishing composition can be measured using a known or conventional zeta potential measurement device. In particular, it can be measured by the method described in the example mentioned later.

An etching rate ER of the polishing composition is not particularly limited, as long as a product with zeta potential ζ falls within a specific range. In view of a surface quality of a polishing face, etc., an etching rate ER of the polishing composition based on the etching rate measurement is usually appropriately 25 µm/h or less, preferably 20 µm/h or less, and more preferably 18 µm/h or less. In some embodiments, the etching rate ER may be 13 µm/h or less, 10 µm/h or less, 8.5 µm/h or less, or 5 µm/h or less. In view of a polishing removal rate, the etching rate ER is usually suitably 2 µm/h or more, preferably 3 µm/h or more, and more preferably 4 µm/h or more. In some embodiments, the etching rate ER may be 7 µm/h or more, 8 µm/h or more, 9 µm/h or more, or 10 µm/h or more. An etching rate ER of the polishing composition can be set corresponding to the type, molecular weight, or content of a water-soluble polymer, the type or content of a basic compound, the presence or absence, type, content, or pH of another additive component added (a surfactant, etc.), or the like.

### <Abrasive>

The polishing composition disclosed herein contains silica particles as an abrasive. Silica particles as an abrasive functions to mechanically polish a surface of an object to be polished. Inclusion of abrasive in the polishing composition allows enhancing a polishing removal rate based on mechanical polishing action from presence of abrasive. When the polishing composition can be used in polishing (e.g., final polishing) of an object to be polished having a surface formed of silicon, such as a silicon wafer as described later, it is particularly significant to employ silica particles as an abrasive.

Specific examples of the silica particles include colloidal silica, fumed silica, and precipitated silica. The silica particles can be used singly or in combination of two or more kinds thereof. Colloidal silica is particularly preferably used because it facilitates production of a polishing surface with an excellent surface grade after polishing. Examples of colloidal silica to be potentially preferably employed include colloidal silica prepared from water glass (sodium silicate) as a raw material by ion-exchanging, and colloidal silica prepared from alkoxide (colloidal silica produced by a hydrolysis-condensation reaction of alkoxysilane). Colloidal silica can be used singly or in combination of two or more kinds thereof.

The absolute specific gravity of silica that forms the silica particles is preferably 1.5 or more, more preferably 1.6 or more, and even more preferably 1.7 or more. The upper limit of the absolute specific gravity of silica is not particularly limited, but is typically 2.3 or less, and e.g., 2.2 or less. As the absolute specific gravity of the silica particles, a measured value derived by liquid replacement using ethanol as a replacing liquid can be employed.

The average primary particle diameter of the abrasive (typically, silica particles) is not particularly limited, but in view of a polishing removal rate, etc., it is preferably 5 nm or more, and more preferably 10 nm or more. In view of providing a higher effect of polishing (an effect such as reduction in haze or removal of a defect), the average primary particle diameter is preferably 15 nm or more, and more preferably 20 nm or more (e.g., more than 20 nm). In view of preventing a scratch, etc., the average primary particle diameter of the abrasive is preferably 100 nm or less, more preferably 50 nm or less, and even more preferably 45 nm or less. In view of producing a lowerhaze surface with ease, the average primary particle diameter of the abrasive in some embodiments may be 43 nm or less, less than 40 nm, less than 38 nm, less than 35 nm, less than 32 nm, or less than 30 nm.

An average primary particle diameter, as used herein, refers to a particle diameter (BET particle diameter) calculated from a specific surface area measured by a BET method (BET value) by the formula: average primary particle diameter (nm) = 6000/(true density (g/cm³) × BET value (m²/g)). The specific surface area can be measured using e.g., a surface area measurement device with the product name of "Flow Sorb II 2300", manufactured by Micromeritics Instrument Corporation.

The average secondary particle diameter of the abrasive (typically, silica particles) is not particularly limited, and can be appropriately selected from, e.g., the range of about 15 nm to 300 nm. In view of improving a polishing removal rate, the average secondary particle diameter is preferably 30 nm or more, and more preferably 35 nm or more. In some embodiments, the average secondary particle diameter may be, e.g., 40 nm or more, 42 nm or more, or preferably 44 nm or more. The average secondary particle diameter is usually, advantageously 250 nm or less, preferably 200 nm or less, and more preferably 150 nm or less. In some preferred embodiments, the average secondary particle diameter is 120 nm or less, more preferably 100 nm or less, and even more preferably 70 nm or less, and may be e.g., 60 nm or less or 50 nm or less.

An average secondary particle diameter, as used herein, refers to a particle diameter (volume average particle diameter) measured by dynamic light scattering. The average secondary particle diameter of the abrasive can be measured by dynamic light scattering using e.g., the product named "NANOTRAC UPA-UT151" manufactured by Nikkiso Co., Ltd.

The shape (outer shape) of the silica particles may be globular or non-globular. Specific examples of the particles having non-globular forms include peanut-shaped (i.e., peanut shellshaped) particles, cocoon-shaped particles, conpeito-shaped particles, and rugby ball-shaped particles. For example, silica particles majorly including peanut-shaped or cocoon-shaped particles may be preferably employed.

Without particular limitation, the average value of major axis/minor axis ratios (average aspect ratio) of the silica particles is theoretically 1.0 or more, preferably 1.05 or more, even more preferably 1.1 or more, and possibly 1.2 or more. Increase in the average aspect ratio can achieve a higher polishing removal rate. In view of reducing scratches, etc., the average aspect ratio of the silica particles is preferably 3.0 or less, more preferably 2.0 or less, even more preferably 1.5 or less, and possibly 1.4 or less.

An exemplary specific procedure for acquiring the shape (outer shape) and the average aspect ratio of the silica particles can be as follows: with use of a scanning electron microscope (SEM), collecting a predetermined number (e.g., 200) of the silica particles each independently having a discriminable shape; drawing a minimum rectangle circumscribed to an image of each of the collected particles; then calculating, as a major axis/minor axis ratio (aspect ratio), a value by dividing the long side length (major axis value) by the short side length (minor axis value) for the rectangle drawn for the image of each of the particles; and deriving the average aspect ratio from an arithmetic average of the aspect ratios for the predetermined number of the particles.

The polishing composition disclosed herein may contain abrasive other than silica particles (hereinafter also referred to as "non-silica abrasive"), as long as an effect of the present invention is not significantly inhibited. Examples of the non-silica abrasive include inorganic particles, organic particles, and organic-inorganic composite particles. Specific examples of the inorganic particles include oxide particles such as alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonate salts such as calcium carbonate and barium carbonate. Specific examples of the organic particles include polymethylmethacrylate (PMMA) particles, poly(meth)acrylic acid particles ((meth)acrylic acid in this context is intended to refer inclusively to acrylic acid and methacrylic acid), and polyacrylonitrile particles. Such abrasive can be used singly or in combination of two or more kinds thereof.

The art disclosed herein can be preferably performed in an embodiment where substantially only silica particles are used as an abrasive. In such a view, the proportion of silica particles in the total amount of abrasive is suitably 90% by weight or more, preferably 95% by weight or more, and more preferably 98% by weight or more (e.g., 99 to 100% by weight).

### <Basic Compound>

The polishing composition disclosed herein contains a basic compound. As used herein, a basic compound refers to a compound having a function to be dissolved in water to rise the pH of an aqueous solution. Inclusion of a basic compound in the polishing composition provides chemical polishing action (alkali etching), by which an object to be polished can be efficiently polished. Available examples of the basic compound include organic or inorganic nitrogen-containing basic compounds, phosphorus-containing basic compounds, hydroxides of alkali metals, hydroxides of alkaline earth metals, and various carbonate salts or hydrogen carbonate salts. Examples of the nitrogen-containing basic compounds include quaternary ammonium compounds, ammonia, amines (preferably, water-soluble amines). Examples of the phosphorus-containing basic compounds include quaternary phosphonium compounds. Such a basic compound can be used singly or in combination of two or more kinds thereof.

Specific examples of the hydroxides of alkali metals include potassium hydroxide and sodium hydroxide. Specific examples of the carbonate salts or hydrogen carbonate salts include ammonium hydrogen carbonate, ammonium carbonate, potassium hydrogen carbonate, potassium carbonate, sodium hydrogen carbonate, and sodium carbonate. Specific examples of the amines include, methylamine, dimethylamine, trimethylamine, ethylamine, diethylamine, triethylamine, ethylenediamine, monoethanolamine, *N*-(β-aminoethyl)ethanolamine, hexamethylenediamine, diethylenetriamine, triethylenetetramine, piperazine anhydride, piperazine hexahydrate, 1-(2-aminoethyl) piperazine, N-methylpiperazine, guanidine, and azoles such as imidazole and triazole. Specific examples of the quaternary phosphonium compounds include quaternary phosphonium hydroxides such as tetramethylphosphonium hydroxide and tetraethylphosphonium hydroxide.

As the quaternary ammonium compound, quaternary ammonium salts (typically, strong bases) such as tetraalkyl ammonium salts and hydroxyalkyl trialkyl ammonium salts can be used. An anion component in such quaternary ammonium salts may be, e.g., OH , F⁻, Cl⁻, Br , I⁻, ClO₄⁻, and BH₄⁻. Examples of the quaternary ammonium compound include quaternary ammonium salts having OH⁻ as an anion, i.e., quaternary ammonium hydroxides. Specific examples of the quaternary ammonium hydroxides include tetraalkyl ammonium hydroxides such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; hydroxyalkyl trialkylammonium hydroxides such as 2-hydroxyethyltrimethylammonium hydroxide (also referred to as choline).

Among these basic compounds, at least one kind of basic compound selected from hydroxides of alkali metal, quaternized ammonium hydroxide, and ammonia can be preferably used, for example. In particular, more preferred are tetraalkyl ammonium hydroxide (e.g., tetramethyl ammonium hydroxide) and ammonia, and particularly preferred is ammonia.

### <Water-soluble polymer>

The polishing composition disclosed herein contains a water-soluble polymer. The water-soluble polymer can serve for protection of a surface to be polished and improvement in wettability of a surface to be polished after polishing, etc. The polishing composition disclosed herein is characterized by containing at least two kinds of water-soluble polymers. In other words, the polishing composition disclosed herein contains a first water-soluble polymer and a second water-soluble polymer.

### <First Water-soluble polymer >

The polishing composition disclosed herein contains a polyvinyl alcohol-based polymer as the first water-soluble polymer. With containing a polyvinyl alcohol-based polymer, the polishing composition tends to provide a polishing surface with high quality. Without being construed with any particular limitation, a polyvinyl alcohol-based polymer is considered to act on a substrate surface to protect a substrate surface, and thereby to contribute to improvement in a polishing surface quality (particularly, reduction in haze). Use of a polyvinyl alcohol-based polymer as the first water-soluble polymer in combination with the second water-soluble polymer provides benefits based on different actions of each water-soluble polymer, and effectively achieves a high surface quality.

As used herein, a polyvinyl alcohol-based polymer refers to a polymer containing a vinyl alcohol unit (hereinafter also referred to as "VA unit") as a repeating unit therein. The polyvinyl alcohol-based polymer can be used singly or in combination of two or more kinds thereof. The polyvinyl alcohol-based polymer may contain only VA units as repeating units, or a repeating unit other than VA units in addition to VA units (hereinafter also referred to as "non-VA unit). The polyvinyl alcohol-based polymer may be a random copolymer, a block copolymer, an alternate copolymer, a graft copolymer, or the like containing a VA unit and a non-VA unit. The polyvinyl alcohol-based polymer may contain only one kind of non-VA unit, or two or more kinds of non-VA units.

The polyvinyl alcohol-based polymer may be an unmodified polyvinyl alcohol (unmodified PVA) or a modified polyvinyl alcohol (modified PVA). An unmodified PVA, as used herein, refers to a polyvinyl alcohol-based polymer that is generated by hydrolyzing (saponifying) polyvinyl acetate and contains substantially no repeating unit other than repeating units having a structure derived by vinyl polymerization of vinyl acetate (-CH₂-CH(OCOCH₃)-) and VA units. The saponification degree of the unmodified PVA may be, e.g., 60% or more, and in view of water solubility, it may be 70% or more, 80% or more, or 90% or more. In some embodiments, the saponifying degree of the unmodified PVA may be 98% or more (completely saponified).

The polyvinyl alcohol-based polymer may be a modified PVA containing a VA unit, and a non-VA unit having at least one structure selected from an oxyalkylene group, a carboxy group, a (di)carboxylic group, a (di)carboxylic ester group, a phenyl group, a naphthyl group, a sulfo group, an amino group, a hydroxy group, an amide group, an imide group, a nitrile group, an ether group, an ester group, and salts thereof. Examples of a non-VA unit that may be contained in the modified PVA may include, but are not limited to, a repeating unit derived from an *N*-vinyl-type monomer, an N (meth)acryloyl-type monomer, or the like as described later, a repeating unit derived from ethylene, a repeating unit derived from alkyl vinyl ether, a repeating unit derived from a vinyl ester of monocarboxylic acid having a carbon atom number of 3 or more, and a repeating unit derived from a (di)acetone compound. A preferred example of the *N*-vinyl-type monomer may be *N-*vinylpyrrolidone. A preferred example of the *N*-(meth)acryloyl-type monomer can be *N-*(meth)acryloyl morpholine. The alkyl vinyl ether may be vinyl ether having an alkyl group having a carbon atom number of 1 or more and 10 or less, such as propylvinyl ether, butyl vinyl ether, or 2-ethylhexylvinyl ether. The vinyl ester of monocarboxylic acid having a carbon atom number of 3 or more may be a vinyl ester of monocarboxylic acid having a carbon atom number of 3 or more and 7 or less, such as vinyl propionate, vinyl butylate, vinyl pentanoate, and vinyl hexanoate. Preferred examples of the (di)acetone compound include diacetone (meth)acrylamide and acetylacetone.

Moreover, in some preferred embodiments, an acetalized polyvinyl alcohol-based polymer is used as the polyvinyl alcohol-based polymer. Examples of the acetalized polyvinyl alcohol-based polymer include a modified PVA where a part of VA units in the polyvinyl alcohol-based polymer are acetalized. A modified PVA (acetalized PVA (ac-PVA)) derived by acetalizing a part of VA units in the polyvinyl alcohol-based polymer can be provided by reacting and acetalizing a part of hydroxy groups in the polyvinyl alcohol-based polymer with an aldehyde compound or a ketone compound. Typically, the acetalized polyvinyl alcohol-based polymer can be provided by an acetalized reaction of the polyvinyl alcohol-based polymer and an aldehyde compound. In some preferred embodiments, the carbon number of the aldehyde compound is 1 to 7, and more preferably 2 to 7.

Examples of the aldehyde compound include formaldehyde; linear or branched alkyl aldehydes such as acetaldehyde, propionaldehyde, *n*-butylaldehyde, isobutylaldehyde, *t-*butylaldehyde, and hexylaldehyde; alicyclic or aromatic aldehydes such as cyclohexanecarbaldehyde and benzaldehyde. These can be used singly or in combination of two or more kinds thereof. The aldehyde compound may also have one or more hydrogen atoms substituted with halogen or the like except for formaldehyde. In particular, in view of high solubility to water and ease of an acetalization reaction, preferred are linear or branched alkyl aldehydes, and particularly more preferred are acetaldehyde, n-propylaldehyde, n-butylaldehyde, and n-pentylaldehyde.

As the aldehyde compound, in addition to the aforementioned substances, an aldehyde compound having a carbon number of 8 or more, such as 2-ethylhexylaldehyde, nonyl aldehyde, or decyl aldehyde, may be used.

The acetalized polyvinyl alcohol-based polymer contains a VA unit of a structural segment represented by the following chemical formula: -CH₂-CH(OH)-, and an acetalized structure unit represented by the following general formula (1) (hereinafter also referred to as "VAC unit"). 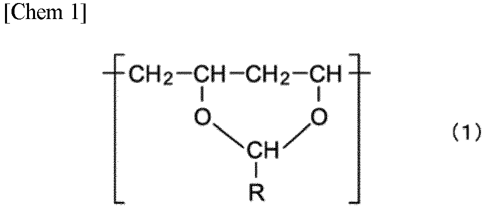 (in the formula (1), R is a hydrogen atom, or a linear or branched alkyl group, and the alkyl group may be substituted by a functional group.)

In some preferred embodiments, R in the formula (1) is a hydrogen atom or a linear or branched alkyl group having a carbon number of 1 to 6. Among these, R may be one kind or a combination of two or more kinds. In view of enhancing performance to reduce haze, R is preferably a linear or branched alkyl chain having a carbon number of 1 to 6.

In view of enhancing performance to reduce haze, the acetalization degree of the acetalized polyvinyl alcohol-based polymer can be 1% by mole or more, may be 5% by mole or more, preferably 10% by mole or more, more preferably 15% by mole or more, even more preferably 20% by mole or more, and particularly preferably 25% by mole or more (e.g., 27% by mole or more). In view of enhancing hydrophilicity, the acetalization degree of the acetalized polyvinyl alcohol-based polymer is preferably less than 60% by mole, further 50% by mole or less, more preferably 40% by mole or less, and particularly preferably 35% by mole or less (e.g., 33% by mole or less). As used herein, the term "acetalization degree" refers to a proportion of acetalized structure units (VAC units) in all repeating units forming an acetalized polyvinyl alcohol-based polymer.

In addition, as a polyvinyl alcohol-based polymer, a cation-modified polyvinyl alcohol in which a cationic group such as a quaternary ammonium structure is introduced may be used. Examples of the cation-modified polyvinyl alcohol include a substance in which a cationic group derived from a monomer having a cationic group such as a diallyl dialkyl ammonium salt or an *N-*(meth)acryloyl aminoalkyl-*N,N,N*-trialkyl ammonium salt. The vinyl alcohol-based polymer may contain a non-VA unit having a structure segment represented by the chemical formula: -CH₂-CH(CR¹ (OR⁴)-CR² (OR⁵)-R³)-. Note that R¹ to R³ each indicate independently a hydrogen atom or an organic group, R⁴ and R⁵ each indicate independently a hydrogen atom or R⁶-CO- (wherein R⁶ indicates an alkyl group). For example, when at least one of R¹ to R³ in the chemical formula is an organic group, the organic group may be a liner or branched alkyl group having a carbon number of 1 or more and 8 or less, etc. R⁶ in the chemical formula may be a linear or branched alkyl group having a number of 1 or more and 8 or less.

In some embodiments, as the modified PVA, a modified PVA having a 1,2-diol structure in a side chain is used. For example, as the modified PVA, a modified PVA with a non-VA unit containing hydrogen atoms as the R¹ to R⁵ (butenediol-vinyl alcohol copolymer (BVOH)) may be preferably employed.

The proportion of the amount by mole of VA units in the amount by mole of all repeating units forming the polyvinyl alcohol-based polymer may be, e.g., 5% or more, 10% or more, 20% or more, or 30% or more. Without particular limitation, in some embodiments, the proportion of the amount by mole of the VA unit may be 50% or more, 65% or more, 75% or more, 80% or more, or 90% or more (e.g., 95% or more or 98% or more). Substantially 100% of repeating units forming the polyvinyl alcohol-based polymer may be VA units. As used herein, the phrase "substantially 100%" refers to not containing, at least intentionally, any non-VA unit in the polyvinyl alcohol-based polymer, and typically encompasses a case that the amount by mole of non-VA units is less than 2% (e.g., less than 1%) in the amount by mole of all repeating units, and a case of 0%. In some other embodiments, the proportion of the amount by mole of VA units in all repeating units forming the polyvinyl alcohol-based polymer may be, e.g., 95% or less, 90% or less, 80% or less, or 70% or less.

The content (content on a weight basis) of VA units in the polyvinyl alcohol-based polymer may be, e.g., 5% by weight or more, 10% by weight or more, 20% by weight or more, or 30% by weight or more. Without particular limitation, in some embodiments, the content of the VA units may be 50% by weight or more (e.g., more than 50% by weight), 70% by weight or more, or 80% by weight or more (e.g., 90% by weight or more, or 95% by weight or more, or 98% by weight or more). Substantially 100% by weight of repeating units forming the polyvinyl alcohol-based polymer may be VA units. As used herein, the phrase "substantially 100% by weight" refers to not containing, at least intentionally, any non-VA unit forming the polyvinyl alcohol-based polymer as a repeating unit, and typically means that the content of non-VA units is less than 2% by weight (e.g., less than 1% by weight) in the polyvinyl alcohol-based polymer. In some other embodiments, the content of VA units in the polyvinyl alcohol-based polymer may be, e.g., 95% by weight or less, 90% by weight or less, 80% by weight or less, or 70% by weight or less.

The polyvinyl alcohol-based polymer may contain a plurality of polymer chains having various contents of VA units within the same molecule. As used herein, a polymer chain refers to a portion (segment) forming a part of a single molecule polymer. For example, the polyvinyl alcohol-based polymer may contain Polymer chain A, where the content of VA units is more than 50% by weight, and Polymer chain B, where the content of VA units is less than 50% by weight (i.e., the content of non-VA units is more than 50% by weight), within the same molecule.

Polymer chain A may contain only VA units as repeating units, or a non-VA unit in addition to VA units. The content of VA units in Polymer chain A may be 60% by weight or more, 70% by weight or more, 80% by weight or more, or 90% by weight or more. In some embodiments, the content of VA units in Polymer chain A may be 95% by weight or more, or 98% by weight or more. Substantially 100% by weight of repeating units forming Polymer chain A may be VA units.

Polymer chain B may contain only non-VA units as a repeating unit, or a VA unit in addition to non-VA units. The content of non-VA units in Polymer chain B may be 60% by weight or more, 70% by weight or more, 80% by weight or more, or 90% by weight or more. In some embodiments, the content of non-VA units in Polymer chain B may be 95% by weight or more, or 98% by weight or more. Substantially 100% by weight of repeating units forming Polymer chain B may be non-VA units.

Examples of a polyvinyl alcohol-based polymer containing Polymer chain A and Polymer chain B within the same molecule include a block copolymer, a graft copolymer, and the like containing these polymer chains. The graft copolymer may be a graft copolymer having a structure of Polymer chain A (main chain) grafted with Polymer chain B (side chain), or a graft copolymer having a structure of Polymer chain B (main chain) grafted with Polymer chain A (side chain). In some embodiments, a polyvinyl alcohol-based polymer having a structure of Polymer chain A grafted with Polymer chain B can be used.

Examples of Polymer chain B include a polymer chain containing a repeating unit derived from an N-vinyl-type monomer as a main repeating unit; a polymer chain containing a repeating unit derived from an N (meth)acryloyl-type monomer as a main repeating unit; a polymer chain containing a repeating unit derived from dicarboxylic vinyl such as fumaric acid, maleic acid, or maleic anhydride, as a main repeating unit; a polymer chain containing a repeating unit derived from an aromatic vinyl monomer such as styrene and vinylnaphthalene as a main repeating unit; and a polymer chain containing an oxyalkylene unit as a main repeating unit. Note that a main repeating unit herein refers to a repeating unit occupying more than 50% by weight unless otherwise stated.

A preferred example of Polymer chain B is a polymer chain containing an N vinyl-type monomer as a main repeating unit, i.e., an *N*-vinyl-based polymer chain. The content of repeating units derived from *N*-vinyl-type monomers in an *N*-vinyl-based polymer chain is typically more than 50% by weight, and may be 70% by weight or more, 85% by weight or more, or 95% by weight or more. Substantially the whole of Polymer chain B may be formed of repeating units derived from *N*-vinyl-type monomers.

Herein, examples of the *N*-vinyl-type monomer include a monomer having a nitrogen-containing heterocycle (e.g., lactam ring), and *N*-vinyl linear amide. Specific examples of the *N-*vinyl lactam-type monomer include *N*-vinylpyrrolidone, *N*-vinylpiperidone, *N*-vinylmorpholinone, *N*-vinylcaprolactam, *N*-vinyl-1,3-oxazine-2-one, and *N*-vinyl-3,5-morpholinedione. Specific examples of the *N*-vinyl linear amide include *N*-vinyl acetoamide, *N*-vinyl propionamide, and *N-*vinyl butyramide. Polymer chain B may be, e.g., an *N*-vinyl-based polymer chain containing *N-*vinylpyrrolidone units occupying more than 50% by weight (e.g., 70% by weight or more, or 85% by weight or more, or 95% by weight or more) of repeating units. Substantially all of repeating units forming Polymer chain B may be *N*-vinylpyrrolidone units.

Other examples of Polymer chain B include a polymer chain containing a repeating unit derived from an *N*-(meth)acryloyl-type monomer as a main repeating unit, i.e., an *N*-(meth)acryloyl-based polymer chain. The content of repeating units derived from *N*-(meth)acryloyl-type monomers in an *N*-(meth)acryloyl-based polymer chain is typically more than 50% by weight, and may be 70% by weight or more, 85% by weight or more, or 95% by weight or more. Substantially the whole of Polymer chain B may be formed of repeating units derived from *N*-(meth)acryloyl-type monomers.

Herein, examples of the *N*-(meth)acryloyl-type monomer include a linear amide having an N (meth)acryloyl group, and a cyclic amide having an *N*-(meth)acryloyl group. Examples of the linear amide having an *N*-(meth)acryloyl group include (meth)acrylamide; *N*-alkyl (meth)acrylamides such as *N*-methyl (meth)acrylamide, *N*-ethyl (meth)acrylamide, *N*-propyl (meth)acrylamide, *N*-isopropyl (meth)acrylamide, and *N*-*n*-butyl (meth)acrylamide; and *N,N*-dialkyl (meth)acrylamide such as *N,N*-dimethyl (meth)acrylamide, *N,N*-diethyl (meth)acrylamide, *N,N-*dipropyl (meth)acrylamide, *N,N-*diisopropyl (meth)acrylamide, and *N,N-*di(*n*-butyl) (meth)acrylamide. Examples of the cyclic amide having an *N*-(meth)acryloyl group include *N-*(meth)acryloyl morpholine and *N*-(meth)acryloyl pyrrolidine.

Other examples of Polymer chain B include a polymer chain containing an oxyalkylene unit as a main repeating unit, i.e., an oxyalkylene-based polymer chain. The content of oxyalkylene units in the oxyalkylene-based polymer chain is typically more than 50% by weight, and may be 70% by weight or more, 85% by weight or more, or 95% by weight or more. Substantially all of repeating units in Polymer chain B may be oxyalkylene units.

Examples of the oxyalkylene unit include an oxyethylene unit, an oxypropylene unit, and an oxybutylene unit. Each of these oxyalkylene units may be a repeating unit derived from a corresponding alkylene oxide. Oxyalkylene units in the oxyalkylene-based polymer chain may consist of one kind or two or more kinds. For example, the oxyalkylene-based polymer chain may contain oxyethylene units and oxypropylene units in combination. In an oxyalkylene-based polymer chain containing two or more kinds of oxyalkylene units, each of these oxyalkylene units may be a random copolymer, a block copolymer, an alternate copolymer, a graft copolymer, or the like of a corresponding alkylene oxide.

Further examples of Polymer chain B include a polymer chain containing a repeating unit derived from alkyl vinyl ether (e.g., vinyl ether with an alkyl group having a carbon atom number of 1 or more and 10 or less), a polymer chain containing a repeating unit derived from monocarboxylic vinyl ester (e.g., vinyl ester of monocarboxylic acid having a carbon atom number of 3 or more), and a polymer chain introducing a cationic group (e.g., a cationic group having a quaternary ammonium structure).

In some embodiments in the art disclosed herein, a polyvinyl alcohol-based polymer as the first water-soluble polymer is preferably a modified polyvinyl alcohol that is a copolymer containing a VA unit and a non-VA unit. The saponification degree of the modified polyvinyl alcohol-based polymer as the first water-soluble polymer is usually 50% by mole or more, preferably 65% by mole or more, more preferably 70% by mole or more, and e.g., 75% by mole or more.

The weight average molecular weight (Mw) of the first water-soluble polymer (particularly, a polyvinyl alcohol-based polymer) can be 100 × 10⁴ or less, and is suitably 60 × 10⁴ or less. In view of concentration efficiency and the like, the Mw may be 30 × 10⁴ or less, preferably 20 × 10⁴ or less, e.g., 10 × 10⁴ or less, 8 × 10⁴ or less, 5 × 10⁴ or less, or 3 × 10⁴ or less. When the polyvinyl alcohol-based polymer has a smaller Mw, the polyvinyl alcohol-based polymer tends to have improved dispersion stability. Additionally, in view of preferably protecting a polishing surface and maintaining or improving a surface quality, the Mw may be e.g., 0.2 × 10⁴ or more, and is usually preferably 0.5 × 10⁴ or more. Increase in the Mw of the polyvinyl alcohol-based polymer leads to a tendency to provide higher effects to protect an object to be polished and increase wettability. In such a view, the Mw in some embodiments is suitably 0.8 × 10⁴ or more, and preferably 1.0 × 10⁴ or more, and may be 2 × 10⁴ or more, 3 × 10⁴ or more, e.g., 4 × 10⁴ or more, or 5 × 10⁴ or more.

As the Mw of the water-soluble polymer, a molecular weight calculated from a value based on aqueous gel permeation chromatography (GPC) (aqueous phase, on polyethylene oxide conversion basis) can be employed. The same applies to the MWs of the first water-soluble polymer described above and the second water-soluble polymer described later. As a GPC measurement device, the machine named "HLC-8320GPC" manufactured by Tosoh Corporation can be used. Measurement can be performed in accordance with, e.g., the following conditions. The same method is also employed to the examples described later.

### [GPC Measurement Conditions]

Sample concentration: 0.1% by weight
Column: TSKgel GMPW_{XL}
Detector: differential refractometer
Elution liquid: 100 mM sodium nitrate aqueous solution
Flow rate: 1 mL/min
Measurement temperature: 40°C
Sample injection volume: 200 µL

Without particular limitation, the content of the first water-soluble polymer (particularly, a polyvinyl alcohol-based polymer) relative to 100 parts by weight of abrasive (typically, silica particles) in the polishing composition in some embodiments can be e.g., 0.01 parts by weight or more, and in view of reducing defects, the content is suitably 0.1 parts by weight or more, preferably 0.5 parts by weight or more, and more preferably 1 part by weight or more, and may be 1.5 part by weight or more, 2 part by weight or more, 3 part by weight or more, or 3.5 part by weight or more. The content of the first water-soluble polymer relative to 100 parts by weight of abrasive may also be, e.g., 50 parts by weight or less, or 30 parts by weight or less. In view of dispersion stability of the polishing composition, etc., the content of the first water-soluble polymer relative to 100 parts by weight of abrasive in some embodiments is suitably 15 parts by weight or less, preferably 10 parts by weight or less, and more preferably 5 parts by weight or less, and may be 3 parts by weight or less, 2.5 parts by weight or less, or 2 parts by weight or less. Appropriate setting of usage of the first water-soluble polymer (particularly, a polyvinyl alcohol-based polymer) from the aforementioned range provides a high surface quality after polishing.

### <Second water-soluble polymer>

The polishing composition disclosed herein contains the second water-soluble polymer in addition to the first water-soluble polymer (particularly, a polyvinyl alcohol-based polymer). The second water-soluble polymer is typically a polymer having a chemical structure different from that of the first water-soluble polymer. The second water-soluble polymer is not particularly limited and can be selected to be used from a variety of polymers, as long as a product of zeta potential ζ [mV] of the polishing composition and an etching rate ER [µm/h] of the polishing composition meets the aforementioned specific requirement.

Examples of the second water-soluble polymer include compounds containing a hydroxyl group, a carboxy group, an acyloxy group, a sulfo group, an amide structure, an imido structure, a quaternary ammonium structure, a heterocyclic structure, a vinyl structure, etc. in a molecule. Available examples of the second water-soluble polymer include cellulose derivatives, starch derivatives, oxyalkylene unit-containing polymers, polyvinyl alcohol-based polymers, nitrogen atom-containing polymers, and (meth)acrylic acid unit-containing polymers. An available embodiment of the nitrogen atom-containing polymers may be an N-vinyl-type polymer, an *N-*(meth)acryloyl-type polymer, or the like. The second water-soluble polymer may be a naturally-occurring polymer or a synthetic polymer.

In some embodiments, a naturally-occurring polymer is used as the second water-soluble polymer. Examples of the naturally-occurring polymer include cellulose derivatives and starch derivatives.

In some embodiments, a cellulose derivative is used as the second water-soluble polymer. As used herein, the cellulose derivative is a polymer that contains a β-glucose unit as a main repeating unit. Specific examples of the cellulose derivative include hydroxyethyl cellulose (HEC), hydroxypropyl cellulose, hydroxyethylmethyl cellulose, hydroxypropylmethyl cellulose, methylcellulose, ethylcellulose, ethylhydroxyethyl cellulose, and carboxy methylcellulose. In particular, HEC is preferred.

In some embodiments, a starch derivative is used as the second water-soluble polymer. The starch derivative is a polymer containing an α-glucose unit as a main repeating unit, and examples thereof include pregelatinized starch, pullulan, carboxymethyl starch, and cyclodextrin.

In some other preferred embodiments, a synthetic polymer is used as the second water-soluble polymer. The effect to improve a surface grade disclosed herein is preferably exerted in an embodiment where a synthetic polymer is used as the second water-soluble polymer.

In some embodiments, an oxyalkylene unit-containing polymer is used as the water-soluble polymer. Examples of the oxyalkylene unit-containing polymer include polyethylene oxide (PEO), a block copolymer of ethylene oxide (EO) and propylene oxide (PO) or butylene oxide (BO), and a random copolymer of EO and PO or BO. In particular, preferred are a block copolymer of EO and PO and a random copolymer of EO and PO. The block copolymer of EO and PO may be a diblock copolymer or a triblock copolymer containing a PEO block and a polypropylene oxide (PPO) block, or the like. Examples of the triblock copolymer include PEO-PPO-PEO type triblock copolymers and PPO-PEO-PPO type triblock copolymers. Usually, more preferred are PEO-PPO-PEO type triblock copolymers.

A copolymer, as used herein, is intended to inclusively refer to various copolymers such as random copolymers, alternate copolymers, block copolymers, and graft copolymers, unless otherwise stated.

In a block copolymer or a random copolymer of EO and PO, the molar ratio (EO/PO) of EO and PO forming the copolymer is preferably more than 1, more preferably 2 or more, and even more preferably 3 or more (e.g., 5 or more) in view of solubility in water, cleanability, etc.

In some preferred embodiments, a polyvinyl alcohol-based polymer is used as the second water-soluble polymer. When the polishing composition contains two or more kinds of polyvinyl alcohol-based polymers, the lower Mw polymer is defined as a first water-soluble polymer, and the higher Mw polymer is defined as a second water-soluble polymer.

In some preferred embodiments, a modified PVA containing, as a non-VA unit, a repeating unit derived from an *N*-vinyl-type monomer or an *N*-(meth)acryloyl-type monomer can be used as the second water-soluble polymer. In another embodiment where the second water-soluble polymer is a polyvinyl alcohol-based polymer, a polyvinyl alcohol-based polymer listed as potentially preferably used as the first water-soluble polymer can be used as the second water-soluble polymer. Examples of preferred polymers are omitted to avoid redundancy.

In some other embodiments, an *N*-vinyl-type polymer may be used as the second water-soluble polymer. Examples of the *N*-vinyl-type polymer include a polymer containing a repeating unit derived from a monomer having a nitrogen-containing heterocycle (e.g., lactam ring). Examples of such a polymer include homopolymers and copolymers of*N*-vinyllactam-type monomers (e.g., a copolymer containing *N*-vinyllactam-type monomers with a copolymerization ratio of more than 50% by weight), and homopolymers and copolymers of *N*-vinyl linear amide (e.g., a copolymer containing *N*-vinyl linear amide with a copolymerization ratio of more than 50% by weight).

Specific examples of the *N*-vinyllactam-type monomer (i.e., a compound having a lactam structure and a *N*-vinyl group within one molecule) include *N*-vinylpyrrolidone (VP), *N-*vinylpiperidone, *N*-vinylmorpholinone, *N*-vinylcaprolactam (VC), *N*-vinyl-1,3-oxazine-2-one, and *N*-vinyl-3,5-morpholinedione. Specific examples of a polymer containing the *N*-vinyllactam-type monomer unit include polyvinyl pyrrolidone; polyvinyl caprolactam; a random copolymer of VP and VC; a random copolymer of one or both of VP and VC with another vinyl monomer (e.g., an acrylic monomer and a vinyl ester-based monomer); and a block copolymer, an alternate copolymer, a graft copolymer, and the like containing a polymer chain containing one or both of VP and VC.

Specific examples of the *N*-vinyl linear amide include *N*-vinylacetoamide, *N*-vinyl-propionamide, and *N*-vinyl butyramide.

In some other embodiments, *N*-(meth)acryloyl-type polymer can be used as the second water-soluble polymer. Examples of the *N*-(meth)acryloyl-type polymer include homopolymers and copolymers of *N*-(meth)acryloyl-type monomers (typically, a copolymer containing *N-*(meth)acryloyl-type monomers with a copolymerization ratio of more than 50% by weight). Examples of the *N*-(meth)acryloyl-type monomers include linear amides containing an *N-*(meth)acryloyl group and cyclic amides containing an *N*-(meth)acryloyl group. As used herein, (meth)acryloyl-type is intended to inclusively refer to acryloyl-types and methacryloyl-types. As used herein, (meth)acryloyl group is intended to inclusively refer to acryloyl groups and an methacryloyl groups.

Examples of the linear amide having an *N*-(meth)acryloyl group include (meth)acrylamides; *N*-alkyl (meth)acrylamides such as *N*-methyl (meth)acrylamide, *N*-ethyl (meth)acrylamide, *N*-propyl (meth)acrylamide, *N*-isopropyl (meth)acrylamide, and *N*-n-butyl (meth)acrylamide; *N,N-*dialkyl (meth)acrylamides such as *N,N*-dimethyl (meth)acrylamide, *N,N-*diethyl (meth)acrylamide, *N,N*-dipropyl (meth)acrylamide, *N,N-*diisopropyl (meth)acrylamide, and *N,N*-di(*n*-butyl) (meth)acrylamide. Other examples thereof include *N*-hydroxyethylacrylamide (HEAA). Examples of a polymer containing the linear amide having an *N*-(meth)acryloyl group as a monomer unit include a homopolymer of *N*-isopropylacrylamide and a copolymer of *N-*isopropylacrylamide (e.g., a copolymer containing *N*-isopropylacrylamide with a copolymerization ratio of more than 50% by weight). As used herein, (meth)acrylamide is intended to inclusively refer to acrylamide and methacrylamide.

Examples of the cyclic amide having an *N*-(meth)acryloyl group include *N-*acryloylmorpholine, *N*-acryloylthiomorpholine, *N*-acryloylpiperidine, *N*-acryloylpyrrolidine, *N-*methacryloylmorpholine, *N*-methacryloylpiperidine, and *N*-methacryloylpyrrolidine. Examples of a polymer containing the cyclic amide having an *N*-(meth)acryloyl group as a monomer unit include an acryloyl morpholine-based polymer (PACMO). Typical examples of the acryloyl morpholine-based polymer include a homopolymer of N-acryloylmorpholine (ACMO) and a copolymer of ACMO (e.g., a copolymer containing ACMO with a copolymerization ratio of more than 50% by weight). In the acryloyl morpholine-based polymer, the proportion of the amount by mole of ACMO units in the amount by mole of all repeating units is usually 50% or more, and suitably 80% or more (e.g., 90% or more, typically 95% or more). All repeating units in the second water-soluble polymer may be substantially occupied by ACMO units.

In some embodiments, a carboxylic acid-based polymer is used as the second water-soluble polymer. Examples of the carboxylic acid-based polymer include maleic acid unit-containing polymers and (meth)acrylic acid unit-containing polymers. Examples of the maleic acid unit-containing polymers include styrene-maleic acid copolymer or salts thereof, styrene-maleic anhydride copolymer, styrenesulfonic acid-maleic acid copolymer or salts thereof, styrenesulfonic acid salt-maleic acid copolymer, and maleic acid-vinyl acetate copolymer. Examples of the (meth)acrylic acid unit-containing polymers include polyacrylic acid or salts thereof, styrene-acrylic acid copolymer or salts thereof, styrenesulfonic acid-acrylic acid copolymer or salts thereof, styrenesulfonic acid salt-acrylic acid copolymer, acrylic acid-vinyl acetate copolymer, and acrylic acid/sulfonic acid-based monomer copolymer. As used herein, (meth)acrylic acid is intended to inclusively mean acrylic acid and methacrylic acid.

When the second water-soluble polymer is a polyvinyl alcohol-based polymer, the Mw of the second water-soluble polymer can be, e.g., 100 × 10⁴ or less, and is suitably 60 × 10⁴ or less. In view of concentration efficiency and the like, the Mw may be 30 × 10⁴ or less, preferably 20 × 10⁴ or less, e.g., 10 × 10⁴ or less, 8 × 10⁴ or less, 5 × 10⁴ or less, or 3 × 10⁴ or less. Additionally, in view of preferably protecting a polishing surface and maintaining or improving a surface quality, the Mw may be, e.g., 0.2 × 10⁴ or more, and is preferably usually 0.5 × 10⁴ or more. Increase in the Mw of the polyvinyl alcohol-based polymer leads to a tendency to provide higher effects to protect an object to be polished and increase wettability. In such a view, the Mw in some embodiments is suitably 0.8 × 10⁴ or more, and preferably 1.0 × 10⁴ or more, and may be 1.2 × 10⁴ or more.

When the second water-soluble polymer is a polymer containing, as a monomer unit, linear amide having an N-(meth)acryloyl group, the Mw of the second water-soluble polymer can be, e.g., 100 × 10⁴ or less, and is suitably 50 × 10⁴ or less. In view of concentration efficiency and the like, the Mw may be 30 × 10⁴ or less, 10 × 10⁴ or less, 8 × 10⁴ or less, or 6 × 10⁴ or less. In view of improving a surface quality, the Mw may be, e.g., 1 × 10⁴ or more, 2 × 10⁴ or more, or 3 × 10⁴ or more (e.g., 4 × 10⁴ or more). Use of the second water-soluble polymer with a high Mw is likely to result in a high surface quality.

When the second water-soluble polymer is a polymer containing, as a monomer unit, cyclic amide having an N-(meth)acryloyl group, the Mw of the second water-soluble polymer can be, e.g., 100 × 10⁴ or less, and is suitably 70 × 10⁴ or less. In view of concentration efficiency and the like, the Mw may be 60 × 10⁴ or less, 50 × 10⁴ or less, or 40 × 10⁴ or less. In view of improving a surface quality, the Mw may be, e.g., 1.0 × 10⁴ or more, 5 × 10⁴ or more, or 10 × 10⁴ or more (e.g., more than 10 × 10⁴). In some embodiments, the Mw is suitably 20 × 10⁴ or more, preferably 25 × 10⁴ or more, and more preferably 30 × 10⁴ or more (e.g., more than 30× 10⁴). Use of the second water-soluble polymer with a high Mw is likely to result in a high surface quality.

When the second water-soluble polymer is a polymer containing a (meth)acrylic acid unit, the Mw of the second water-soluble polymer can be, e.g., 800 × 10⁴ or less, and is suitably 500 × 10⁴ or less. In view of concentration efficiency and the like, the Mw may be 300 × 10⁴ or less, preferably 200 × 10⁴ or less, e.g., 175 × 10⁴ or less, 150 × 10⁴ or less, or 140 × 10⁴ or less. In view of preferably protecting a polishing surface to maintain and improve a surface quality, the Mw may be, e.g., 20 × 10⁴ or more, 50 × 10⁴ or more, or 100 × 10⁴ or more (e.g., 130 × 10⁴ or more). Use of the second water-soluble polymer with a high Mw is likely to result in a high surface quality.

When the second water-soluble polymer is a polymer containing an oxyalkylene unit, the Mw of the second water-soluble polymer can be 10 × 10⁴ or less, and may be 5 × 10⁴ or less, 3 × 10⁴ or less, or 2 × 10⁴ or less. The Mw can be 1 × 10⁴ or more, and may be 1.2 × 10⁴ or more, or 1.5 × 10⁴ or more.

Without particular limitation, in some embodiments, a substance having a Mw higher than the Mw of the first water-soluble polymer can be preferably used as the second water-soluble polymer. Use of the Mws of two kinds of water-soluble polymers having such relative Mws preferably achieves a high surface quality after polishing.

Without particular limitation, in some embodiments, the content of the second water-soluble polymer in the polishing composition relative to 100 parts by weight of abrasive (typically silica particles) can be, e.g., 0.01 parts by weight or more, and in view of reduction in haze, etc., it is suitably 0.1 parts by weight or more, preferably 0.5 parts by weight or more, more preferably 1 part by weight or more, and possibly 2 parts by weight or more. The content of the second water-soluble polymer relative to 100 parts by weight of abrasive may also be, e.g., 50 parts by weight or less, or 30 parts by weight or less. In view of dispersion stability of the polishing composition, etc., the content of the second water-soluble polymer relative to 100 parts by weight of abrasive in some embodiments is suitably 15 parts by weight or less, preferably 10 parts by weight or less, and more preferably 5 parts by weight or less, and may be, e.g., 3.5 parts by weight or less. Appropriate setting of usage of the second water-soluble polymer from the aforementioned range can result in a high surface quality.

Without particular limitation, in some embodiments, the ratio (B/(C1 + C2)) of the content of a basic compound (B) to the total content of water-soluble polymers (C1 + C2) in the polishing composition can be, e.g., 0.01 or more on a weight basis is suitably 0.1 or more, preferably 0.2 or more, more preferably 0.5 or more, and possibly 0.7 or more, on a weight basis in view of a polishing removal rate, etc. The ratio (B/(C1 + C2)) of the content of a basic compound (B) to the total content of water-soluble polymers (C1 + C2) in the polishing composition may also be, e.g., 15 or less, or 10 or less on a weight basis. Additionally in view of preferably protecting a polishing surface to maintain and improve a surface quality, the ratio of the contents is suitably 7 or less, preferably 5 or less, and more preferably 2 or less, or may be, e.g., 1 or less. Appropriate setting of the ratio of the content of a basic compound (B) to the total content of water-soluble polymers (C1 + C2) from the aforementioned range can result in a high surface quality.

Without particular limitation, in some embodiments, the total content of water-soluble polymers in the polishing composition relative to 100 parts by weight of abrasive (typically silica particles) can be, e.g., 0.01 parts by weight or more, and in view of improving a surface quality, etc., it is suitably 0.1 parts by weight or more, preferably 0.5 parts by weight or more, more preferably 1 parts by weight or more, even more preferably 2 parts by weight or more, particularly preferably 4 parts by weight or more, and possibly 6 parts by weight or more. The total content of the water-soluble polymers relative to 100 parts by weight of abrasive may also be, e.g., 50 parts by weight or less, or 30 parts by weight or less. In view of dispersion stability of the polishing composition, etc., the total content of the water-soluble polymers relative to 100 parts by weight of abrasive in some embodiments is suitably 15 parts by weight or less, preferably 12 parts by weight or less, and possibly 10 parts by weight or less (e.g., less than 10 parts by weight).

Without particular limitation, in some embodiments, the ratio (W2/W1) of the content W2 of the second water-soluble polymer to the contentW1 of the first water-soluble polymer is, e.g., 0.01 or more, suitably 0.1 or more, and preferably 0.2 or more, and may be 0.4 or more, 0.6 or more, or 0.8 or more, on a weight basis. The upper limit of the ratio (W2/W1) is, e.g., 10 or less, suitably 5 or less, preferably 3 or less, more preferably less than 2, and possibly 1 or less (less than 1) on a weight basis. Appropriate settings of the ratio (W2/W1) within the aforementioned range can leads to preferable exertion of an effect of the art disclosed herein.

The polishing composition disclosed herein may contain a water-soluble polymer other than the first water-soluble polymer and the second water-soluble polymer (hereinafter also referred to as an optional water-soluble polymer) as an optional component, as long as an effect of the present invention is not significantly prevented.

In an embodiment where the polishing composition contains an optional water-soluble polymer, the content ratio of the optional water-soluble polymer to the total water-soluble polymers in the polishing composition is not particularly limited, but in view of efficiently exerting actions of first water-soluble polymer and second water-soluble polymer, it is suitably, approximately 50% by weight or less (e.g., less than 50% by weight), and may be 30% by weight or less, less than 10% by weight, less than 3% by weight, or less than 1% by weight. The art disclosed herein may preferably be performed in an embodiment where the polishing composition contains substantially no optional water-soluble polymer.

### <Surfactant>

In some embodiments, the polishing composition preferably contains at least one kind of surfactant. Inclusion of a surfactant in the polishing composition can reduce haze on a polished surface. According to the art disclosed herein, composition containing the combination of water-soluble polymers described above and a surfactant enables more improvement in a quality of a polishing surface. As the surfactant, any of anionic, cationic, nonionic, or amphoteric substance is available. Usually, an anionic or nonionic surfactant can be preferably employed. In view of low foamability, ease of pH adjustment, etc., a nonionic surfactant is more preferable. Examples thereof include oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenylether, polyoxyethylene alkyl amine, polyoxyethylene fatty acid ester, polyoxyethylene glycerylether fatty acid ester, and polyoxyethylene sorbitan fatty acid ester; and copolymers of plural kinds of oxyalkylene (e.g., diblock type copolymers, triblock type copolymers, random type copolymers, and alternate copolymers). The surfactant can be used singly or in combination of two or more kinds thereof.

Specific examples of the nonionic surfactant include block copolymers of ethylene oxide (EO) and propylene oxide (PO) (diblock type copolymers, PEO (polyethylene oxide)-PPO (polypropylene oxide)-PEO type triblock units, PPO-PEO-PPO type triblock copolymers, etc.), random copolymers of EO and PO, polyoxyethylene glycol, polyoxyethylene propylether, polyoxyethylene butylether, polyoxyethylene pentylether, polyoxyethylene hexylether, polyoxyethylene octylether, polyoxyethylene-2-ethylhexylether, polyoxyethylene nonylether, polyoxyethylene decylether, polyoxyethylene isodecylether, polyoxyethylene tridecylether, polyoxyethylene laurylether, polyoxyethylene cetylether, polyoxyethylene stearylether, polyoxyethylene isostearylether, polyoxyethylene oleylether, polyoxyethylene phenylether, polyoxyethylene octylphenylether, polyoxyethylene nonylphenylether, polyoxyethylene dodecylphenylether, polyoxyethylene styrated phenylether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, and polyoxyethylene castor wax. Particularly preferred examples of the surfactant include block copolymers of EO and PO (in particular, PEO-PPO-PEO type triblock copolymers), random copolymers of EO and PO, and polyoxyethylene alkyl ether (e.g., polyoxyethylene decylether). As such polyoxyethylene alkyl ether, a substance in which the number of EO moles added is about 1 to 10 (e.g., about 3 to 8) can be preferably employed.

In some embodiments, a nonionic surfactant is preferably used. Use of a nonionic surfactant tends to further enhance performance to reduce haze.

The molecular weight of the surfactant is, e.g., less than 1 × 10⁴, and in view of filterability, cleanability, etc., it is preferably 9500 or less, and may be, e.g., less than 9000. In view of interfacial action or the like, the molecular weight of the surfactant is also usually, suitably 200 or more, and in view of an effect to reduce haze or the like, it is preferably 250 or more (e.g., 300 or more). The more preferred range of the molecular weight of the surfactant may also be varied corresponding to the type of the surfactant. For example, when polyoxyethylene alkyl ether is used as a surfactant, the molecular weight is preferably e.g., less than 2000, more preferably 1900 or less (e.g., less than 1800), and even more preferably 1500 or less, and may be 1000 or less (e.g., 500 or less). In addition, for example, when a block copolymer of EO and PO is used as a surfactant, the weight average molecular weight thereof may be, e.g., 500 or more, 1000 or more, and further 1500 or more, 2000 or more, and further 2500 or more. The upper limit of the weight average molecular weight, e.g., less than 1 × 10⁴, and preferably 9500 or less, and may be, e.g., less than 9000, less than 7000, or less than 5000.

As the molecular weight of the surfactant, a molecular weight calculated from a chemical formula may be employed, or a value of a weight average molecular weight derived by GPC (aqueous phase, on polyethylene glycol conversion basis) may be employed. For example, polyoxyethylene alkyl ether preferably employs a molecular weight calculated from a chemical formula, and a block copolymer of EO and PO preferably employs a weight average molecular weight derived by the GPC as described above.

Without particular limitation, in an embodiment where the polishing composition contains a surfactant, the content of the surfactant relative to 100 parts by weight of abrasive (typically, silica particles) is, in view of cleanability and the like, suitably 20 parts by weight or less, preferably 10 parts by weight or less, and more preferably 6 parts by weight or less (e.g., 3 parts by weight or less). In view of better exerting an effect of use of the surfactant, the content of the surfactant relative to 100 parts by weight of abrasive is suitably 0.001 parts by weight or more, preferably 0.01 parts by weight or more, and more preferably 0.1 parts by weight or more, and may be 0.5 parts by weight or more.

### <Water>

Examples of water in the polishing composition disclosed herein to be potentially preferably used include ion-exchanged water (deionized water), pure water, ultrapure water, and distilled water. In water to be used, the content of transition metal ions is preferably, e.g., 100 ppb or less in total, in order to avoid inhibiting a function of another component in the polishing composition as much as possible. For example, water can have improved purity by removal of impurity ions by ion-exchange resin, removal of contaminants by a filter, distillation, etc. The polishing composition disclosed herein may further contain an organic solvent that can be uniformly mixed with water (lower alcohol, lower ketone, etc.), as appropriate. In a solvent(s) in the polishing composition, water preferably accounts for 90% by volume or more, and more preferably 95% by volume or more (e.g., 99 to 100% by volume).

### <Other components>

The polishing composition disclosed herein may further contain, as appropriate, a known additive that can be used for a polishing composition (e.g., a polishing composition used for a final polishing step of a silicon wafer), such as organic acid, an organic acid salt, inorganic acid, an inorganic acid salt, a chelator, an antiseptic agent, or an antifungal agent, as long as an effect of the present invention is not significantly inhibited.

The organic acid and salts thereof, and inorganic acid and salts thereof can be used singly or in combination of two or more kinds thereof. Examples of the organic acid include aliphatic acids such as formic acid, acetic acid, and propionic acid; aromatic carboxylic acids such as benzoic acid and phthalic acid; itaconic acid; citric acid; oxalic acid; tartaric acid; malic acid; maleic acid; fumaric acid; succinic acid; glycolic acid; malonic acid; gluconic acid; alanine; glycine; lactic acid; hydroxyethylidene diphosphoric acid (HEDP); organic sulfonic acid such as methanesulfonic acid; nitrilotris (methylenephosphoric acid) (NTMP); and organic phosphonic acid such as phosphonobutane tricarboxylic acid (PBTC). Examples of the organic acid salt include alkali metal salts (sodium salts, potassium salts, etc.) and ammonium salts of organic acid. Examples of the inorganic acid include hydrochloric acid, phosphoric acid, sulfuric acid, phosphonic acid, nitric acid, phosphinic acid, boric acid, and carbonic acid. Examples of the inorganic acid salt include alkali metal salts (sodium salts, potassium salts, etc.) and ammonium salts of inorganic acid.

The chelator can be used singly or in combination of two or more kinds thereof. Examples of the chelator include aminocarboxylic acid-based chelators and organic phosphonic acid-based chelators. Preferred examples of the chelators include ethylenediamine tetrakis(methylenephosphinic acid), diethylene triamine penta(methylenephosphinic acid), and diethylene triamine pentaacetic acid. Examples of the antiseptic agent and antifungal agent include isothiazoline-based compounds, paraoxybenzoic acid esters, and phenoxyethanol.

The polishing composition disclosed herein preferably contains substantially no oxidant. This is because when the polishing composition contains an oxidant, supply of the polishing composition to a substrate (e.g., a silicon wafer) can cause oxidation on a surface of the substrate and generate an oxide layer, thereby reducing a polishing removal rate. Specific examples of an oxidant in this context include hydrogen peroxide (H₂O₂), sodium persulfate, ammonium persulfate, and sodium dichroloisocyanurate. The phrase that the polishing composition contains substantially no oxidant means not containing an oxidant at least intentionally. Accordingly, when inevitably containing a small amount of an oxidant (e.g., the molar concentration of an oxidant in the polishing composition is 0.001 mole/L or less, preferably 0.0005 mole/L or less, more preferably 0.0001 mole/L or less, even more preferably 0.00005 mole/L or less, and particularly preferably 0.00001 mole/L or less) derived from a raw material, a product method, etc., the polishing composition can be encompassed within the concept of a polishing composition containing substantially no oxidant in this context.

### <pH>

The pH of the polishing composition disclosed herein is not particularly limited, and suitable pH can be employed corresponding to a substrate, etc. In some embodiments, the pH of the polishing composition is appropriately 8.0 or more, preferably 8.5 or more, and more preferably 9.0 or more. Higher pH of the polishing composition tends to lead to increase in a polishing removal rate. Meanwhile, in view of preventing dissolution of silica particles and suppressing reduction in action of mechanical polishing, the pH of the polishing composition is usually, suitably 12.0 or less, preferably 11.0 or less, more preferably 10.8 or less, and even more preferably 10.5 or less.

In the art disclosed herein, the pH of the polishing composition can be known by performing three-point calibration with standard buffers (a phthalate pH buffer with pH 4.01 (25°C), a neutral phosphate pH buffer with pH 6.86 (25°C), and a carbonate pH buffer with pH 10.01 (25°C)) using a pH meter (e.g., a glass-electrode hydrogen ion concentration indicator (model: F-72) manufactured by Horiba, Ltd.), and then inserting a glass electrode into a composition to be measured, leaving it to stand for 2 minutes or more until stabilization and conducting measurement.

### <Polishing Slurry>

The polishing composition disclosed herein is typically supplied onto a surface of a substrate in form of a polishing slurry containing the polishing composition, and used for polishing the substrate. The polishing slurry can be, e.g., prepared by diluting any of the polishing compositions disclosed herein (typically, diluting with water). Alternatively, the polishing composition may be used directly as a polishing slurry. Other examples of the polishing slurry containing the polishing composition disclosed herein include a polishing slurry formed by adjusting the pH of the composition.

The content of abrasive (typically, silica particles) in a polishing removal rate is not particularly limited, and is, e.g., 0.005% by weight or more, preferably 0.01% by weight or more, more preferably 0.03% by weight or more, and even more preferably 0.06% by weight or more. Increase in the content of abrasive can provide a higher polishing removal rate. The content is suitably 10% by weight or less, preferably 7% by weight or less, more preferably 5% by weight or less, and even more preferably 2% by weight or less, and may be, e.g., 1% by weight or less, 0.5% by weight or less, or 0.4% by weight or less. This facilitates achieving maintenance of a surface quality.

The content of a basic compound in a polishing slurry is not particularly limited. In view of improving a polishing removal rate, the content is usually, suitably 0.0005% by weight or more, preferably 0.001% by weight or more, and more preferably 0.003% by weight or more. In view of improving a surface quality (e.g., reduction in haze), etc., the content is suitably less than 0.1% by weight, preferably less than 0.05% by weight, and more preferably less than 0.03% by weight (e.g., less than 0.025% by weight, and further, less than 0.01% by weight).

Without particular limitation, in some embodiments, the content W1 of the first water-soluble polymer (particularly, a polyvinyl alcohol-based polymer) in a polishing slurry may be, e.g., 0.0001% by weight or more, and is usually, suitably 0.0005% by weight or more, and preferably 0.001% by weight or more, and may be, e.g., 0.002% by weight or more, or 0.003% by weight or more, in view of improving a surface quality, etc. The upper limit of the content W1 of the first water-soluble polymer is not particularly limited, and can be, e.g., 0.05% by weight or less. In view of stability or a polishing removal rate, cleanability in a concentrated liquid form, etc., the content W1 of the first water-soluble polymer in some embodiments is preferably 0.03% by weight or less, more preferably 0.015% by weight or less, and even more preferably 0.01% by weight or less. The polishing slurry disclosed herein can be prepared even in an embodiment e.g., where the content W1 of the first water-soluble polymer is 0.008% by weight or less, 0.006% by weight or less, or 0.004% by weight or less.

Without particular limitation, in some embodiments, the content W2 of the second water-soluble polymer in a polishing slurry may be, e.g., 0.0001% by weight or more, and is usually, suitably 0.0005% by weight or more, and preferably 0.001% by weight or more, and may be, e.g., 0.002% by weight or more, 0.003% by weight or more, or 0.005% by weight or more in view of improving a surface quality, etc. The upper limit of the content W2 of the second water-soluble polymer is not particularly limited, and can be, e.g., 0.1% by weight or less. In view of stability or a polishing removal rate, cleanability in a concentrated liquid form, etc., the content W2 of the second water-soluble polymer in some embodiments is preferably 0.05% by weight or less, more preferably 0.02% by weight or less, and even more preferably 0.01% by weight or less.

The total content of water-soluble polymers in the polishing slurry is not particularly limited, and can be, e.g., 0.0001% by weight or more in some embodiments. In view of reduction in haze, etc., the total content is preferably 0.0005% by weight or more, more preferably 0.001% by weight or more, and even more preferably 0.002% by weight or more, and may be, e.g., 0.005% by weight or more. The upper limit of the total content is, e.g., 0.5% by weight or less, and in view of a polishing removal rate, etc., it is preferably 0.2% by weight or less, more preferably 0.1% by weight or less, and even more preferably 0.05% by weight or less (e.g., 0.02% by weight or less, and further, 0.015% by weight or less).

In presence of a surfactant, the content of the surfactant in a polishing slurry (the total content in presence of two or more kinds of surfactants) is not particularly limited, as long as an effect of the present invention is not significantly prevented. Usually, the content of the surfactant can be, e.g., 0.00001% by weight or more in view of cleanability, etc. In view of reduction in haze, etc., the content is preferably 0.0001% by weight or more, more preferably 0.0003% by weight or more, and even more preferably 0.0005% by weight or more. In view of a polishing removal rate, etc., the content is preferably 0.1% by weight or less, more preferably 0.01% by weight or less, and even more preferably 0.005% by weight or less (e.g., 0.002% by weight or less).

### <Concentrated Liquid>

The polishing composition disclosed herein may be a concentrated form (i.e., a concentrated liquid form of a polishing slurry) before supply to a substrate. Such a concentrated form of the polishing composition is advantageous in view of convenience, cost reduction, etc. in production, distribution, storage, etc. The concentration factor is not particularly limited, can be, e.g., about 2-fold to 100-fold in volume, and is usually, suitably about 5-fold to 50-fold (e.g., about 10-fold to 40-fold). Such a concentrated liquid can be diluted at a desired timing to prepare a polishing slurry (a working slurry), and can be used in an embodiment of supplying the polishing slurry to a substrate. The dilution can be performed, e.g., by adding water to the concentrated liquid and mixing them.

When the polishing composition (i.e., a concentrated liquid) is diluted and used for polishing, the content of abrasive in the concentrated liquid can be, e.g., 25% by weight or less. In view of dispersion stability, filterability, etc. of the polishing composition, the content is usually, preferably 20% by weight or less, and more preferably 15% by weight or less. In some preferred embodiments, the content of abrasive may be 10% by weight or less, or 5% by weight or less. In view of convenience and cost reduction, etc. in production, distribution, storage, etc., the content of abrasive in the concentrated liquid can also be, e.g., 0.1% by weight or more, and is preferably 0.5% by weight or more, more preferably 0.7% by weight or more, and even more preferably 1% by weight or more.

In some embodiments, the content of a basic compound in the concentrated liquid can be, e.g., less than 0.25% by weight. In view of storage stability, etc., the content is usually, preferably 0.15% by weight or less, and more preferably 0.1% by weight or less. In view of convenience, cost reduction, etc. in production, distribution, storage, etc., the content of a basic compound in the concentrated liquid can also be, e.g., 0.005% by weight or more, preferably 0.01% by weight or more, more preferably 0.02% by weight or more, and even more preferably 0.05% by weight or more.

In some embodiments, the total content of water-soluble polymers in the concentrated liquid can be, e.g., 3% by weight or less. In view of filterability, cleanability, and the like of the polishing composition, the content is usually, preferably 1% by weight or less, and more preferably 0.5% by weight or less. In view of convenience, cost reduction, etc. in production, distribution, storage, etc., the content is also usually, suitably 0.001% by weight or more, preferably 0.005% by weight or more, and more preferably 0.01% by weight or more.

In an embodiment where the polishing composition contains a surfactant, the content of a surfactant in the concentrated liquid can be, e.g., 0.25% by weight or less, preferably 0.15% by weight or less, and more preferably 0.1% by weight or less, and may be 0.05% by weight or less, or 0.025% by weight or less. The content of a surfactant in the concentrated liquid can also be, e.g., 0.0001% by weight or more, preferably 0.001% by weight or more, more preferably 0.005% by weight or more, and even more preferably 0.01% by weight or more.

### <Preparation of Polishing Composition>

The polishing composition in the art disclosed herein may be a single-agent type or a multi-agent type such as a two-agent type. For example, the composition may be configured to prepare a polishing slurry by mixing of Part A, which contains at least abrasive among components of the polishing composition, and Part B, which contains at least a part of the remaining components, and mixing and diluting them at a suitable timing, as appropriate.

A preparation method of the polishing composition is not particularly limited. For example, a well-known mixing device such as a blade stirrer, an ultrasonic disperser, or a homomixer can be used to mix each component included in the polishing composition. An embodiment of mixing these components is not particularly limited, and for example, all components may be mixed at a time or may be mixed in an order preset appropriately.

### <Application>

The polishing composition disclosed herein can be applied to polishing of substrates with various material qualities and shapes. Examples of materials of the substrates include metals or semimetals such as silicon materials, aluminum, nickel, tungsten, copper, tantalum, titanium, and stainless steel, or alloys thereof, glassy substances such as quartz glass, aluminosilicate glass, and glassy carbon; ceramic materials such as alumina, silica, sapphire, silicon nitride, tantalum nitride, and titanium carbide; compound semiconductor substrate materials such as silicon carbide, gallium nitride, and gallium arsenide; and resin materials such as polyimide resins. In particular, the substrate may be formed of a plurality of materials. The shape of a substrate is not particularly limited. The polishing composition disclosed herein can be applied to polishing of a substrate having a plane that has, e.g., a plate shape or a polyhedron shape, or polishing of an end of a substrate (e.g., polishing of a wafer edge).

The polishing composition disclosed herein can be particularly preferably used for polishing of a surface formed of a silicon material (typically, polishing of a silicon wafer). Specific examples of the silicon material include silicon single crystal, amorphous silicon, and polysilicon. The polishing composition disclosed herein can be particularly preferably used for polishing of a surface formed of silicon single crystal (e.g., polishing of a silicon wafer).

The polishing composition disclosed herein can be preferably applied to a polishing step of a substrate (e.g., a silicon wafer). The substrate may be subjected to common treatment that can be applied to a substrate in a step upstream from a polishing step, such as lapping or etching, before a polishing step with the polishing composition disclosed herein.

The polishing composition disclosed herein is effective for use in a final step or an immediately preceding polishing step of a substrate (e.g., a silicon wafer), and use in a final polishing step is particularly preferred. The final polishing step in this context refers to a last polishing step (i.e., a step preceding no further polishing) in a production process of an object of interest. The polishing composition disclosed herein may also be used for a polishing step upstream from a final polishing (that refers to a stock polishing step between a rough polishing step and a last polishing step, typically includes at least a primary polishing step, and may further include a secondary, tertiary or more-order polishing step(s)), e.g., a polishing step performed just before final polishing.

The polishing composition disclosed herein is effective in application to polishing (typically, final polishing or the preceding polishing thereof) of e.g., a silicon wafer prepared to have a surface with a surface roughness of 0.01 nm to 100 nm through an upstream step. Application to final polishing is particularly preferred. The surface roughness Ra of a substrate can be measured using e.g., the laser scanning surface roughness meter "TMS-3000WRC" manufactured by Schmitt Measurement System Inc.

### <Polishing>

The polishing composition disclosed herein can be used for polishing of a substrate e.g., in an embodiment including the following operation. Description will now be made for a preferred embodiment of a method of polishing a silicon wafer as a substrate with use of the polishing composition disclosed herein.

In other words, a polishing slurry containing any of the polishing compositions disclosed herein is provided. Provision of the polishing slurry may include subjecting the polishing composition to operation such as concentration adjustment (e.g., dilution), pH adjustment, etc., thereby preparing the polishing slurry. Alternatively, the polishing composition may be directly used as a polishing slurry.

Then, the polishing slurry is supplied to a substrate, and polishing is carried out by a common method. For example, in final polishing of a silicon wafer, typically, a silicon wafer that experienced a lapping step is set in a typical polishing machine, and then the polishing slurry is supplied via a polishing pad of the polishing machine onto a surface to be polished in the silicon wafer. Typically, while the polishing slurry is consecutively supplied, a polishing pad is pushed against a surface to be polished of a silicon wafer and both are relatively moved (e.g., rotatably moved). Through such a polishing step, polishing of a substrate is completed.

A polishing pad used in the polishing step is not particularly limited. For example, polishing pads such as a foamed polyurethane type, a non-woven fabric type, and a suede type can be used. Each polishing pad may or may not contain abrasive. Usually, a polishing pad containing no abrasive is preferably used.

A substrate polished using the polishing composition disclosed herein is typically cleaned. Cleaning can be performed using a suitable cleaning liquid. A cleaning liquid to be used herein is not particularly limited. For example, SC-1 cleaning liquid (a mixture solution of ammonium hydroxide (NH₄OH), hydrogen peroxide (H₂O₂), and water (H₂O)), SC-2 cleaning liquid (a mixture solution ofHCl, H₂O₂, and H₂O), etc., which are common in the art of semiconductors or the like, can be used. Temperature of a cleaning liquid can be, e.g., within the range of room temperature (typically, about 15°C to 25°C) or higher to about 90°C. In view of improving an effect of cleaning, a cleaning liquid at 50°C to 85°C can be preferably used.

As mentioned above, the art disclosed herein may include providing a method of producing a polished material including a polishing step (preferably, final polishing) by any of the aforementioned polishing methods (e.g., a method of producing a silicon wafer) and a polished material (e.g., a silicon wafer) produced by the method.

### [Examples]

Several examples relating to the present invention will be described below, but the present invention is not intended to be limited to the embodiments shown in the examples. In the following description, "part" and "%" are on a weight basis unless otherwise specified.

### <Preparation of Polishing Composition>

### (Example 1)

An abrasive, a basic compound, water-soluble polymers, a surfactant, and deionized water were mixed to prepare a concentrated liquid of a polishing composition according to each example. As the abrasive, colloidal silica with an average primary particle diameter of 25 nm was used. As the basic compound, ammonia was used. As the water-soluble polymers, acetalized polyvinyl alcohol with a Mw of about 1.3 × 10⁴ (ac-PVA; a first water-soluble polymer; acetalization degree: 24 mol%), and a random copolymer containing vinyl alcohol units and N-vinylpyrrolidone units at a molar ratio of 90: 10 and having a Mw of about 1.4 × 10⁴ (PVA-r-PVP; a second water-soluble polymer) were used. As a surfactant, polyoxyethylene decyl ether (C10EO5) with a number of ethylene oxide moles added of 5 was used. The concentrated liquid of a polishing composition thus obtained was diluted 40 times by volume ratio with deionized water, thereby providing a polishing composition according to each example containing each component with the following concentration: 0.08% an abrasive, 0.005% a basic compound, 0.003% ac-PVA, 0.001% PVA-r-PVP, and 0.0006% C10EO5.

### (Example 2)

As the second water-soluble polymer, poly(*N*-hydroxyethylacrylamide) (PHEAA) with a Mw of about 4.9 × 10⁴ wasused. The concentration of PHEAA was set to 0.002%. Except for these, the polishing composition according to the example was prepared in the same manner as in Example 1.

### (Example 3)

As the first water-soluble polymer, alkyl group-modified PVA with a Mw of about 6000 (a hydrophobic modified PVA) was used. As the second water-soluble polymer, polyacryloylmorpholine (PACMO) with a Mw of about 35 × 10⁴ was used. The concentration of PACMO was set to 0.004%. Except for this, a polishing composition according to the example was prepared in the same manner as in Example 1. The alkyl group-modified PVA used in the example was a random copolymer having vinyl alcohol units and n-propylvinylether units at a molar ratio of 85:15.

### (Example 4)

As the first water-soluble polymer, completely saponified polyvinyl alcohol (PVA) (saponification degree: 98% or more) with a Mw of about 7.0 × 10⁴ was used. As the second water-soluble polymer, polyacrylic acid (PAA) with a Mw of about 136 × 10⁴ was used. The concentration of PVA was set to 0.003%, and the concentration of PAA was set to 0.005%. Except for this, a polishing composition according to the example was prepared in the same manner as in Example 3.

### (Example 5)

The concentration of the basic compound was set to 0.010%. Except for this, a polishing composition according to the example was prepared in the same manner as in Example 4.

### (Example 6)

The concentration of the basic compound was set to 0.015%. Except for this, a polishing composition according to the example was prepared in the same manner as in Example 4.

### (Comparative Example 1)

As the second water-soluble polymer, poly(vinylmethylether) (PVME) was used. The concentration of PVME was set to 0.003%. Except for this, a polishing composition according to the example was prepared in the same manner as in Example 1.

### (Comparative Example 2)

As the first water-soluble polymer, a butenediol-vinyl alcohol copolymer (BVOH) with a side chain having a 1,2-diol structure and a Mw of 20000 was used. As the second water-soluble polymer, polyacryloylmorpholine (PACMO) with a Mw of about 35 × 10⁴ was used. The concentration of BVOH was set to 0.003%, and the concentration of PACMO was 0.004%. Except for this, a polishing composition according to the example was prepared in the same manner as in Example 1. The saponification degree of the butenediol-vinyl alcohol copolymer is 95% or more.

### (Comparative Example 3)

As the first water-soluble polymer, completely saponified polyvinyl alcohol (PVA) (saponification degree: 98% or more) with a Mw of about 7.0 × 10⁴ was used. As the second water-soluble polymer, hydroxyethyl cellulose (HEC) with a Mw of about 28 × 10⁴ was used. The concentration of PVA was set to 0.003%, and the concentration of HEC was 0.009%. In addition, the concentration of C10EO5 was set to 0.0005%. Except for this, a polishing composition according to the example was prepared in the same manner as in Example 1.

### <Measurement of Zeta Potential>

The zeta potential ζ [mV] was measured for each polishing composition under the following conditions using a zeta potential measurement device. The model "Zetasizer nano ZSP" manufactured by Malvern Panalytical Ltd. was used as the measurement device. The measurement results are shown in corresponding columns in Table 1.

### [Measurement Conditions for Zeta Potential]

Dispersion medium: water
Measurement temperature: 25°C
Model: Smoluchowski

An etching rate ER [µm/h] was derived for each polishing composition, based on etching rate measurement. The results are shown in Table 1.

The product (ζ × ER) [nmV/h] of the zeta potential ζ [mV] and the etching rate ER [µm/h] was calculated for the polishing composition of each example. The values thus obtained are shown in corresponding columns in Table 1.

### <Polishing of Silicon Wafer>

As a substrate, a silicon wafer was prepared by lapping and etching a commercially available silicon single crystal wafer (conduction type: P type; crystal orientation: <100>; COP (crystal originated particle: crystal defect) free) with a diameter of 300 mm that was then subjected to preliminary polishing under Polishing condition 1 as follows. The preliminary polishing was performed using a polishing slurry containing 0.6% an abrasive (colloidal silica with an average primary particle diameter of 35 nm) and 0.08% tetramethylammonium hydroxide (TMAH) in deionized water.

### [Polishing Condition 1]

Polishing machine: a sheet-fed polishing machine manufactured by Okamoto Machine Tool Works, Ltd., model "PNX-332B"
Polishing load: 20 kPa
Rotation speed of platen: 20 rpm
Rotation speed of head (carrier): 20 rpm
Polishing pad: manufactured by Fujibo Ehime Co., Ltd., product name "FP55"
Supply rate of polishing slurry: 1.0 L/min
Temperature of polishing slurry: 20°C
Temperature of platen cooling water: 20°C
Polishing time: 2 mins

Using the polishing composition according to each of the examples prepared as described above as a polishing slurry, the silicon wafer after preliminary polishing was polished under Polishing condition 2 as follows.

### [Polishing Condition 2]

Polishing machine: a sheet-fed polishing machine manufactured by Okamoto Machine Tool Works, Ltd., model "PNX-332B"
Polishing load: 20 kPa
Rotation speed of platen: 52 rpm
Rotation speed of head (carrier): 50 rpm
Polishing pad: manufactured by Fujibo Ehime Co., Ltd., product name "POLYPAS275NX"
Supply rate of polishing slurry: 1.5 L/min
Temperature of polishing slurry: 20°C
Temperature of platen cooling water: 20°C
Polishing time: 4 mins

The polished silicon wafer was removed from the polishing machine, and cleaned with a cleaning liquid having NH₄OH (29%) : H₂O₂ (31%) : deionized water (DIW) = 2:5.3:48 (volume ratio) (SC-1 cleaning). More particularly, a first cleaning tank equipped with an ultrasonicator was provided, then the cleaning liquid was charged in the first cleaning tank and kept at 70°C, and the polished silicon wafer was immersed in the cleaning tank for 6 minutes. Subsequently, the silicon wafer was immersed in a second cleaning tank containing deionized water (DIW) at 25°C for 15 minutes, then immersed again in the first cleaning tank for 6 minutes, and in the second cleaning tank for 16 minutes, and dried.

### <Measurement of LPD-N and Haze-line>

The number of LPD-N and haze-line on a silicon wafer surface after cleaning were measured on DC mode using the wafer testing device commercially named "Surfscan SP5" from KLA-Tencor Corporation (current KLA Corporation). The number of LPD-N thus measured is shown in Table 1. The haze-line thus measured was then converted to a relative value to the haze-line of Comparative Example 1 as 10000 and filled in Table 1. LPD-N means light point defect non-cleanable. Haze-line refers to the total area of micro-scratches in a measured area measured by the aforementioned testing device.

Summary and evaluation results of each example are shown in Table 1. In the tables, "-" indicates unmeasurable or measurable.

### [Table 1]

**Table 1**

| | Polishing composition | | | | | | | Physical properties | | | Evaluation | |
|---|---|---|---|---|---|---|---|---|---|---|---|---|
| | First water-soluble polymer | | | Second water-soluble polymer | | | Basic compound | ζ potential [mV] | ER [µm/h] | ζxER [nmV/h] | LPD-N [number] | Haze line (relative value) |
| | Type | Mw [x10⁴] | Content [wt% ] | Type | Mw [x10⁴] | Content [wt% ] | Content [wt% ] | | | | | |
| Ex.1 | Ac-PVA | 1.3 | 0.003 | PVA-r-PVP | 1.4 | 0.001 | 0.005 | -39 | 8 | -312 | 35 | 2 |
| Ex.2 | Ac-PVA | 1.3 | 0.003 | PHEAA | 4.9 | 0.002 | 0.005 | -38 | 8 | -304 | 24 | 0 |
| Ex.3 | hydrophobic modified PVA | 0.60 | 0.003 | PACMO | 35 | 0.004 | 0.005 | -30 | 4 | -120 | 19 | 5 |
| Ex.4 | PVA | 7.0 | 0.003 | PAA | 136 | 0.005 | 0.005 | -46 | 9 | -414 | 38 | 6 |
| Ex.5 | PVA | 7.0 | 0.003 | PAA | 136 | 0.005 | 0.010 | -46 | 14 | -644 | 45 | 5 |
| Ex.6 | PVA | 7.0 | 0.003 | PAA | 136 | 0.005 | 0.015 | -47 | 19 | -893 | 57 | 5 |
| Comp.Ex.1 | Ac-PVA | 1.3 | 0.003 | PVME | - | 0.003 | 0.005 | -35 | 1 | -35 | 457 | 10000 |
| Comp.Ex.2 | BVOH | 2.0 | 0.003 | PACMO | 35 | 0.004 | 0.005 | -32 | 2 | -64 | 119 | 2871 |
| Comp.Ex.3 | PVA | 7.0 | 0.003 | HEC | 28 | 0.009 | 0.005 | -11 | 6 | -66 | 68 | 88 |

Table 1 shows that the polishing compositions according to Examples 1 to 6, which contains a polyvinyl alcohol-based polymer as a first water-soluble polymer, and a second water-soluble polymer having a chemical structure other than that of the first water-soluble polymer in a polishing composition containing silica particles, a basic compound, and water, and in which a product (ζ × ER) of zeta potential ζ [mV] and an etching rate ER [µm/h] is -900 nmV/h or more and -90 nmV/h or less, significantly reduced both the number of LPD-N and haze-line and achieved a high surface quality relative to the polishing compositions according to Comparative Examples 1 to 3, in which the ζ × ER is larger than -90 nmV/h.

While specific examples of the present invention have been described above in detail, these are only illustrative, and do not limit the scope of the claims. The technologies recited in the claims include various modifications and alternations of the specific examples illustrated above.

## Claims

1. A polishing composition comprising silica particles (A) as an abrasive, a basic compound (B), a first water-soluble polymer (C1), a second water-soluble polymer (C2), and water (D),
wherein the first water-soluble polymer (C1) is a polyvinyl alcohol-based polymer;
wherein a product (ER × ζ) of an etching rate ER [µm/h] of the polishing composition and zeta potential ζ [mV] of the polishing composition is -900 nmV/h or more and -90 nmV/h or less; and
wherein the etching rate ER [µm/h] is calculated based on etching rate measurement as follows:
(1) prepare the polishing composition as a liquid agent for etching rate measurement LE;
(2) prepare a silicon single crystal substrate (having a rectangular shape with 6 cm in length, 3 cm in width, and 775 µm in thickness) by immersion in a cleaning liquid of NH₄OH (29%) : H₂O₂ (31%) : deionized water (DIW) = 2:5.3:48 (volume ratio) at 25°C for 1 minute and then in an aqueous hydrogen fluoride (HF) solution (5%) at 25°C for 30 seconds, and measure weight W0 of the silicon single crystal substrate;
(3) immerse the silicon single crystal substrate in the liquid agent LE at 25°C for 48 hours;
(4) remove the silicon single crystal substrate from the liquid agent LE, and clean the silicon single crystal substrate with a cleaning liquid of NH₄OH(29%) : H₂O₂(31%) : deionized water (DIW) = 1:1:8 (volume ratio) at 25°C for 10 seconds;
(5) after cleaning, measure weight W1 of the silicon single crystal substrate; and
(6) calculate the etching rate [µm/h] from a difference between the W0 and the W1 and the specific gravity of the silicon single crystal substrate.

2. The polishing composition according to claim 1, wherein the first water-soluble polymer (C1) is one or two or more kinds selected from the group consisting of unmodified polyvinyl alcohols with a saponification degree of 70% or more; acetalized polyvinyl alcohol-based polymers; and polyvinyl alcohol-based polymers containing repeating units derived from alkylvinyl ether.

3. The polishing composition according to claim 1 or 2, wherein the content of the first water-soluble polymer (C1) relative to 100 parts by weight of the abrasive is 0.5 parts by weight or more and 10 parts by weight or less.

4. The polishing composition according to any one of claims 1-3, wherein the second water-soluble polymer (C2) is one or two or more kinds selected from the group consisting of polyvinyl alcohol-based polymers having a chemical structure different from that of the first water-soluble polymer (C1); nitrogen atom-containing polymers; and (meth)acrylic acid unit-containing polymers.

5. The polishing composition according to claim 4, wherein the nitrogen atom-containing polymers are polymers containing, as a monomer unit, linear amide having an N-(meth)acryloyl group.

6. The polishing composition according to any one of claims 1-5, wherein the content of the second water-soluble polymer (C2) relative to 100 parts by weight of the abrasive is 0.5 parts by weight or more and 10 parts by weight or less.

7. The polishing composition according to any one of claims 1-6, further comprising a surfactant (E).

8. The polishing composition according to claim 7, wherein the surfactant (E) is a nonionic surfactant.

9. The polishing composition according to any one of claims 1-8, for use in polishing a surface made of a silicon material.

10. A concentrated liquid of the polishing composition according to any one of claims 1-9.
